# EUROPEAN PATENT APPLICATION

(11) **EP 2 602 663 A1**
(43) Date of publication of application: **12.06.2013**
(21) Application number: 11192877.6
(22) Date of filing: 09.12.2011
(51) Int. Cl.: G03F 9/00

(54) **System and method for overlay control**

(71) Applicant: Nederlandse Organisatie voor Toegepast -Natuurwetenschappelijk Onderzoek TNO, 2628 VK Delft (NL)
(72) Inventor: Lexmond, Axel Sebastiaan, 2628 VK Delft (NL); van Zwet, Erwin John, 2628 VK Delft (NL); Maas, Diederik Jan, 2628 VK Delft (NL)
(74) Representative: Jansen, Cornelis Marinus

(57) **Abstract**

There is disclosed a chip die manufacturing system and method providing real-time overlay measurement and/or control. In use, an alignment mark 23 on a wafer comprises a patterned material 123 having a fluorescent frequency-shifted response to exposure radiation 15 of the radiation source 5 and the mask pattern 32 comprises a corresponding marker scan pattern 24 forming a matched pair with the alignment mark 23, such that during the projecting of the chip die pattern 22 a fluorescent signal 14 emanating from parts of the alignment mark 23 irradiated by exposure radiation 15 of the radiation source 5 by the marker scan pattern 24 is directed towards a position sensor 8. The position sensor 8 is arranged for detecting the fluorescent signal 14 and providing real-time input Ss to a feedback circuit 9 providing feedback to a position controller 7. The position controller 7 is arranged for adjusting a position of a wafer stage 2 and/or reticle stage 3 during or directly after the projecting of the chip die pattern 25 as a function of said real-time feedback.

## Description

### FIELD AND BACKGROUND OF THE INVENTION

The present invention relates to the field of overlay control in semiconductor manufacturing, in particular to a system and method for controlling overlay between a first and second exposure pattern, e.g. for the manufacturing of a chip die.

In the processing of silicon wafers to create chip dies, a sequence of manufacturing steps may be used wherein the wafer is exposed to different patterns, e.g. for techniques such as double patterning and/or for the deposition of different materials onto the wafer. The term "overlay" is used to refer to the pattern-to-pattern alignment in this sequence of manufacturing steps. In order for the final chip device to function correctly, the overlay should be accurate enough such that the various patterns of e.g. lines, contacts, and transistors are properly aligned and connected. As the industry is driven by a desire for ever smaller chip die patterns, the need for accurate overlay control is becoming more critical.

U.S. Patent No. 4,780,615 by Suzuki discloses an alignment system usable in a semiconductor device manufacturing exposure apparatus for superimposingly transferring a circuit pattern of a reticle onto each of patterns formed on individual portions of a semiconductor wafer, for sequentially aligning the individual portions of the wafer with respect to the reticle by use of alignment marks formed in or on scribe lines defined between the individual portions of the wafer. An optical system for detecting the alignment marks is disposed outside the path of light used for the sake of pattern transfer. In the course of movement of the wafer for bringing a particular shot area to an exposure station, the alignment marks for the particular shot area are photoelectrically detected through the mark detecting optical system and, on the basis of the detection of the alignment marks, the reticle and the wafer are relatively moved into alignment such that, when the particular shot area reaches the exposure station, the pattern of the reticle can be accurately superimposed on the pattern already formed on the particular shot area of the wafer. As a result, TTL (through-the-lens) alignment is assured without degradation of throughput of the exposure apparatus.

There is a need for more accurate alignment in systems for chip die manufacturing.

### SUMMARY OF THE INVENTION

In a first aspect there is provided a chip die manufacturing system. The chip die manufacturing system comprises a wafer stage, a reticle stage, an illumination system, a projection system, a position controller, a position sensor, and a feedback circuit. The wafer stage is arranged for holding and positioning a wafer. The reticle stage is arranged for holding and positioning a reticle comprising a mask pattern comprising a chip die pattern. The illumination system is arranged for irradiating the mask pattern with exposure radiation from a radiation source. The projection system is arranged for projecting patterned exposure radiation from the mask pattern onto the wafer. The position controller is arranged for controlling a position of the wafer stage and/or the reticle stage. The position sensor is arranged for detecting a position of the wafer by means of an alignment mark on the wafer. The feedback circuit is arranged for receiving input from the position sensor and providing feedback to the position controller for adjusting the position of the wafer stage and/or reticle stage as a function of said feedback.

In use, an alignment mark comprises a patterned material having a fluorescent frequency-shifted response to the exposure radiation of the radiation source. The mask pattern comprises a corresponding marker scan pattern forming a matched pair with the alignment mark, such that during the projecting of the chip die pattern a fluorescent signal, emanating from parts of the alignment mark irradiated by patterned exposure radiation of the marker scan pattern, is directed towards the position sensor. The position sensor is arranged for detecting the fluorescent signal and providing real-time input to the feedback circuit. The feedback circuit is arranged for providing real-time feedback to the position controller. The position controller is arranged for adjusting a position of the wafer stage and/or the reticle stage during or directly after the projecting of the chip die pattern as a function of said real-time feedback.

By using an alignment mark comprising a fluorescent material having a frequency-shifted response to the radiation of the radiation source, the alignment mark can be scanned simultaneously with the exposing of the chip die pattern, enabling real-time (i.e. during exposing) feedback on the position of the chip die pattern relative to the alignment mark. Because the same light beam is used for exposing the chip die pattern and scanning the alignment mark, the projection system can be used for both tasks simultaneously. Because the feedback is real-time, the alignment system may react quicker to positional deviations making it more accurate. Furthermore, because the scanning of the position can be performed through the lens (TTL) by applying a marker scan pattern on the same mask as the chip die pattern, there is a fixed relation between the position of the marker scan pattern and the chip die pattern, further enhancing the accuracy of the alignment system. Furthermore, the marker scan pattern can be projected close to the chip die pattern, which helps alleviate misalignment due to deformations of the wafer (e.g. by local heating). Furthermore, because the response of the fluorescent material is frequency shifted, it can be conveniently separated from the light of the radiation source, which may enhance the signal to noise ratio of the detection and ultimately the accuracy of the alignment.

In a second aspect there is provided a method for position control in a chip die manufacturing system. The method comprises holding and positioning the wafer. The method further comprises holding and positioning a reticle comprising a mask pattern comprising a chip die pattern. The method further comprises irradiating the mask pattern with exposure radiation from a radiation source. The method further comprises projecting an image of the mask pattern onto the wafer. The method further comprises controlling a position of the wafer stage and/or the reticle stage. The method further comprises detecting a position of the wafer by means of an alignment mark on the wafer. The method further comprises providing feedback of the detected position of the wafer for adjusting the position of the wafer and/or reticle as a function of said feedback.

In the method, the alignment mark comprises a patterned material having a fluorescent frequency-shifted response to the exposure radiation of the radiation source and the mask pattern comprises a corresponding marker scan pattern forming a matched pair with the alignment mark, such that during the projecting of the chip die pattern a fluorescent signal, emanating from parts of the alignment mark irradiated by patterned exposure radiation of the marker scan pattern is detected for providing real-time feedback for adjusting a position of the wafer and/or the reticle during or directly after the projecting of the chip die pattern as a function of said real-time feedback.

In a third aspect there is provided a semiconductor wafer for use in a lithographic apparatus. The wafer comprises a fluorescent material having a fluorescent frequency-shifted response to exposure radiation that is used for exposing chip die patterns on the wafer in the said lithographic apparatus.

It is noted that U.S. Patent Application 2010/301458 discloses in one of its embodiments a dye compound that is fluorescent at a wavelength band corresponding to an alignment system wavelength to increase contrast of an alignment target in a lithographic double patterning process. The dye may be selected such that it leaves the performance of the resist at the actinic wavelength unaffected and only impacts the resist transparency at the aligning wavelength. It follows that the alignment system wavelength of U.S. Patent Application 2010/301458 operates at a different wavelength than the actinic wavelength, i.e. that of the exposure radiation. Different from U.S. Patent Application 2010/301458 wherein alignment is done conventionally with a separate alignment system, it is currently disclosed to use the exposure radiation itself to provide real-time alignment of the wafer during the exposing of a chip-die pattern. Thereto the currently disclosed fluorescent material on the wafer is chosen such that it responds to the exposure radiation, instead of to the wavelength of a separate alignment system which may have an entirely different wavelength.

### BRIEF DESCRIPTION OF THE DRAWINGS

These and other features, aspects, and advantages of the apparatus, systems and methods of the present invention will become better understood from the following description, appended claims, and accompanying drawing wherein:
FIG 1 shows an embodiment of a chip die manufacturing system.
FIG 2 shows an embodiment of a method for position control in a chip die manufacturing system.
FIG 3 shows an example of an alignment mark and corresponding marker scan pattern.
FIG 4 shows steps of aligning the alignment mark and marker scan pattern of FIG 3.
FIG 5 shows a process of applying a first and second pattern to a wafer.
FIG 6 shows a detail of an embodiment of the alignment mark being positioned according to the method of FIG 2.
FIG 7 shows another embodiment of the alignment mark being positioned according to the method of FIG 2.
FIG 8 shows a graph of fluorescence intensity as a function of overlap between the alignment mark and the marker scan pattern.
FIG 9 shows a graph of fluorescence difference between a pair of alignment marks.
FIG 10 shows a first embodiment of a position sensor.
FIG 11 shows a second embodiment of a position sensor.
FIG 12 shows a third embodiment of a position sensor.
FIG 13 shows a fourth embodiment of a position sensor.

### DETAILED DESCRIPTION

The following detailed description of certain exemplary embodiments is merely exemplary in nature and is in no way intended to limit the invention, its application, or uses. The description is therefore not to be taken in a limiting sense. In the description, reference is made to the accompanying drawings which form a part hereof, and in which are shown by way of illustration specific embodiments in which the described devices and methods may be practiced. These embodiments are described in sufficient detail to enable those skilled in the art to practice the presently disclosed systems and methods, and it is to be understood that other embodiments may be utilized and that structural and logical changes may be made without departing from the spirit and scope of the present system. Moreover, for the purpose of clarity, detailed descriptions of well-known devices and methods are omitted so as not to obscure the description of the present system.

The currently disclosed system and method may find application in the field of lithography, e.g. for double patterning (DPT) immersion lithography but also Extreme Ultra Violet (EUV, typically around 13 nm) lithography. Conventionally, during exposing of a chip die, the correct position of the wafer can not be measured directly. Instead, this position is conventionally measured by determining the position of the wafer table. For double patterning which is currently the leading technology for the 32 nm node, there may be difficulties keeping the overlay control within the required specifications, especially when the wafer position is no longer fixed with respect to the wafer table. Because the currently disclosed system and method allow for measuring the overlay during exposure, it becomes possible to realize real-time overlay control. By partially exposing fluorescent markers on a wafer the overlay may be determined with greater accuracy. In an advantageous method, wherein the markers are applied concurrently with a first lithography step and the measurement of the overlay is preformed concurrently in a second lithography step, a more accurate double patterning overlay may be realized.

Further advantages and applications may become more apparent from the following detailed description of the drawings. This description again is to be regarded in an illustrative and non-limiting manner. In particular, steps and/or parts of the shown embodiments may be omitted and/or added without departing from the scope of the current methods and systems, which scope is defined by the appended claims.

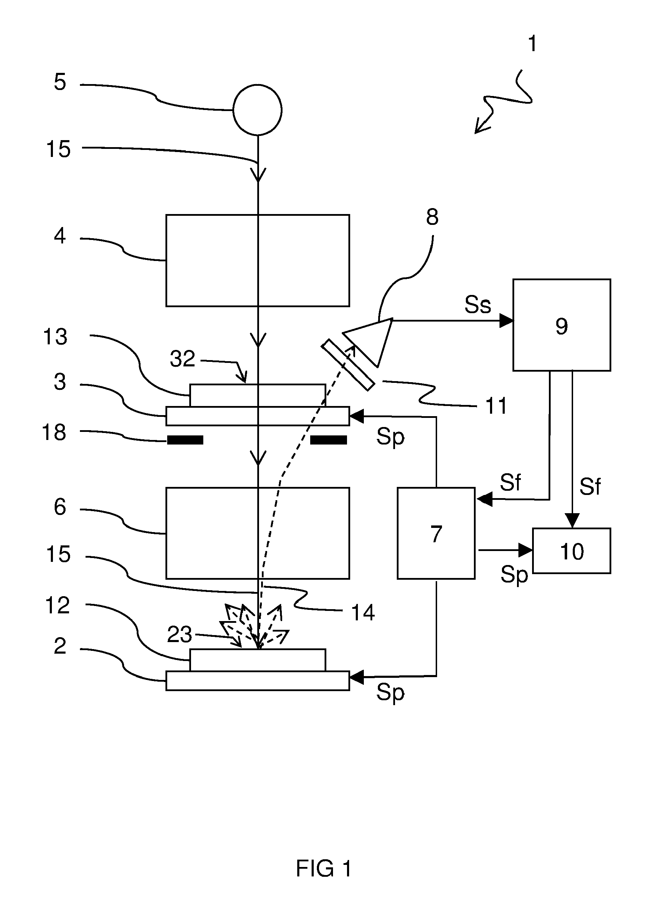

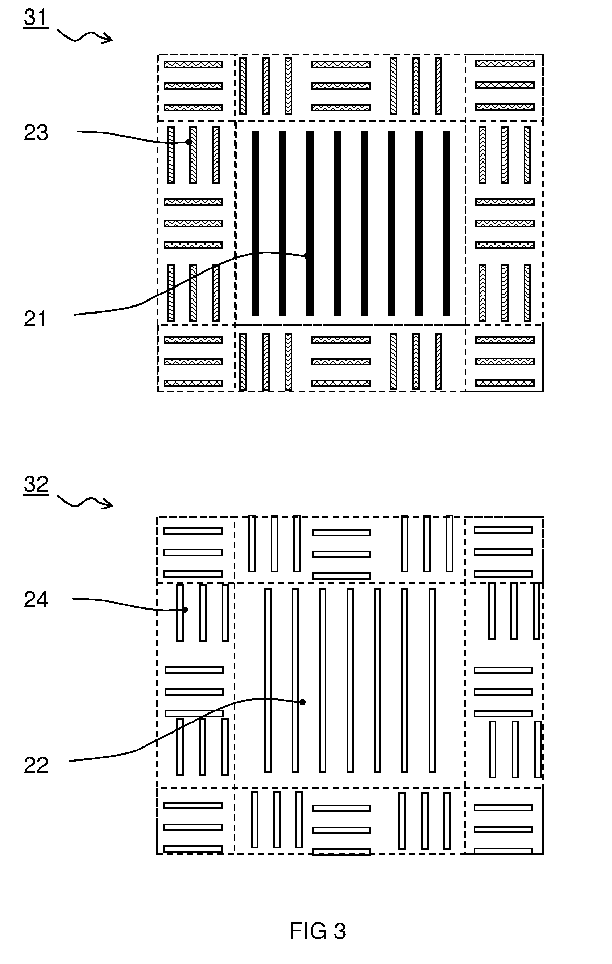

FIG 1 shows an embodiment of a chip die manufacturing system 1. The chip die manufacturing system 1 comprises a wafer stage 2, a reticle stage 3, an illumination system 4, and a projection system 6. The wafer stage 2 is arranged for holding and positioning a wafer 12. The reticle stage 3 is arranged for holding and positioning a reticle 13. The reticle 13 typically comprises a mask pattern 32 comprising a chip die pattern as will be illustrated later with reference to FIG 3. The illumination system 4 is arranged for irradiating the mask pattern 32 with exposure radiation 15 from a radiation source 5. The projection system 6 is arranged for projecting an image of the mask pattern 32 onto the wafer 12. The mask pattern 32 is typically projected on the wafer 12 with a specific demagnification using a patterned expose beam.

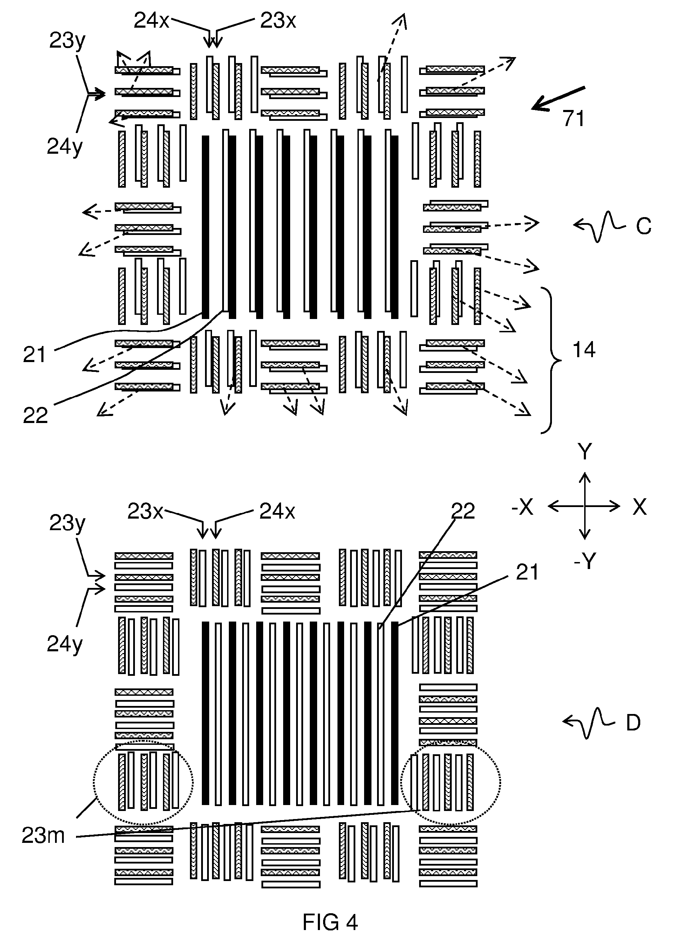

The chip die manufacturing system 1 further comprises a position controller 7, a position sensor 8, and a feedback circuit 9. The position controller 7 is arranged for controlling a position of the wafer stage 3 and/or the reticle stage 2. The position sensor 8 is arranged for detecting a position of the wafer 12 by means of an alignment mark 23 on the wafer 12 pattern as will be illustrated later with reference to FIG 4. The feedback circuit 9 is arranged for receiving input from the position sensor 8 and providing feedback to the position controller 7 for adjusting the position of the wafer stage 2 and/or reticle stage 3 as a function of said feedback.

In use, the system is provided with a wafer 5 comprising an alignment mark 23 that comprises a patterned material 123 having a fluorescent frequency-shifted response to the exposure radiation 15 of the radiation source 5. The system is further provided with a reticle 13 comprising a mask pattern 32 that comprises a corresponding marker scan pattern forming a matched pair with the alignment mark 23, such that during the projecting of the chip die pattern a fluorescent signal 14 emanating from parts of the alignment mark 23 irradiated by exposure radiation 15 of the radiation source 5 by the marker scan pattern is directed towards the position sensor 8.

The position sensor 8 is arranged for detecting this fluorescent signal 14 and for providing a real-time, i.e. during the exposing of the chip die pattern, input signal Ss to the feedback circuit 9. The feedback circuit 9 is arranged for providing real-time feedback Sf to the position controller 7, and the position controller 7 is arranged for adjusting a position of the wafer stage 2 and/or the reticle stage 3 using signal Sp during and/or directly after the projecting of the chip die pattern 25 as a function of said real-time feedback Sf.

An advantage of adjusting the position during exposure may be to prevent a misaligned pattern from forming in the resist layer on the wafer. In an advantageous embodiment the real-time feedback and position control is faster than the exposure time required to form the pattern in the resist layer. An advantage of adjusting the position after exposure may be to prevent a next chip die pattern to suffer from the misalignment, detected in the current exposure step.

In an embodiment, the alignment mark 23 is located on a scribe line between chip dies to be created on the wafer 12 and the projection system 6 is arranged for projecting the marker scan pattern 24 comprised in the mask pattern 32 onto the said scribe line.

At the wafer, the expose beam 15 generates a fluorescent signal 14, typically having a longer wavelength, a broader spectrum and being less-collimated than the expose beam 15. This fluorescent signal 14 is to be detected to provide the real-time overlay monitoring. In one embodiment, the fraction of the fluorescence re-entering the optical column (dashed line ray in this figure) is used. For instance, by a detector or position sensor 8 close to the reticle 3. The sensor 8 may be placed e.g. in front of or behind the reticle. Optionally the system may comprise blades 18 forming an aperture for the light transmitting through or entering the reticle 13. The sensor 8 may e.g. be placed between the blades 18 and the projection system 6, such that the sensor is shielded from the exposure radiation 5 of the radiation source 5. The optical column may typically project the fluorescence signal 14 from the wafer back into the projection system 6. Due to the optical (chromatic) aberrations of the column and the non-collimated character of a fluorescent beam, a significant portion of the fluorescence signal may be projected on the blades.

In the shown embodiment, the position sensor 8 is arranged for detecting the fluorescent signal 14 by means of an optional radiation filter 11. The radiation filter 11 is arranged in a light path of the fluorescent signal 14 between the alignment mark 23 on the wafer 12 and the position sensor 8. The radiation filter 11 is arranged for filtering out radiation 15 from the radiation source 5 while passing the fluorescent signal 14 to the position sensor 8. Thereto the radiation filter 11 may e.g. comprise a dichroic mirror, polarization filter or other suitable optical element that filters out the radiation 15 from the radiation source 5 while passing the fluorescent signal 14. In this respect it is to be appreciated that the fluorescent signal is not only frequency shifted but may also be randomly polarized while the radiation 15 may be linearly polarized. While in the shown embodiment, the radiation filter 11 is arranged for transmitting the fluorescence signal 14 and reflecting or absorbing the radiation 15, in an alternative arrangement, the radiation filter 11 may reflect the fluorescence signal 14 towards the position sensor 8 while transmitting the radiation 15 in another direction.

It is to be appreciated that because the fluorescent signal 14 is frequency-shifted with respect to the radiation 15 of the radiation source 5, the fluorescent signal 14 traveling back through the projection system 14 may follow a different path from the path of the radiation 15 scattered by the wafer 12. This may be e.g. due to chromatic aberration, spherical aberration, polarization effects, or differing reflection characteristics of the various optical element that make up the projection system such as lenses, mirrors, and or polarizers.

Accordingly, in a further embodiment that can be used alternatively or in combination with the radiation filter 11, the projection system 6 is arranged in a light path of the fluorescent signal between the alignment mark 23 on the wafer 12 and the position sensor 8. In other words, the position sensor 8 may be placed on the other side of the projection system 8 with respect to the wafer 12. This arrangement may be beneficial e.g. when the projection system 6 is placed very close to the wafer 12 leaving little room for the position sensor. Such close arrangements may e.g. improve the numerical aperture of the projection system.

Alternatively or in addition, by adding optical elements (e.g. dichroic filters and/or coatings, polarizers, etc.) to the projection system 6, it may be possible to optically separate the fluorescence from the expose beam to facilitate the detection. In another embodiment, the fluorescence detector is integrated in e.g. the immersion hood (not shown), which may be part of the projection system and is by design very close to the exposed wafer. In another embodiment, the detector could be integrated in one of the mirrors that are part of the optical column, e.g. when the DUV reflective coating is made transparent for (part of) the fluorescent spectral range.

In the currently shown embodiment the feedback signal Sf, indicating the degree of alignment or misalignment of the chip die pattern being projected, is used as an input to the position controller 7. The position controller 7 may use this feedback to provide real-time corrections to the position or scanning trajectory of the wafer 12 and/or reticle 13. Alternatively or in addition, this feedback signal Sf may also be used for keeping track of, i.e. record, the registered misalignments.

Thereto, in an embodiment, the system 1 may further comprise a memory device 10 operatively linked to the feedback device and the position controller 7. The severity of the misalignments during projection may be a function of (e.g. proportional to) a magnitude of the fluorescence signal 14 that is translated into the feedback signal Sf. The position of the chip suffering from the said misalignment may be retrieved e.g. from the position signal Sp of the position controller 7. The memory device 10 may thus comprise a list of entries with the alignment status of various positions on the wafer 12.

The real-time and the stored information on the alignment error can be used to improve the alignment in subsequent exposures in a number of ways. Firstly, the real-time overlay error signal may be used to improve the positioning of the reticle projection on the wafer by providing real-time correction signals to the reticle stage, lens actuators and/or the wafer stage position control. Secondly, the recorded and stored overlay error signals can be used to improve the overlay error for subsequent exposures in a number of ways. For instance, feed-forward correction of alignment can be improved by using the overlay fingerprint from the previous die to the next die on the same wafer, or for the same die on the next wafer, or alternatively by correcting the average overlay error with the ensemble overlay error of all dies on one wafer.

Depending on the severity of the misalignments registered by the memory device 10 it may be decided e.g. by a control logic of the position controller to mark the particular chip die on the wafer as being presumed faulty. Once a chip die is marked as faulty, the position controller 7 may e.g. skip the location of the faulty chip die in a multi patterning process, thus saving production time and/or increasing production yield. Alternatively or in addition the faulty chip die may be separated from the other chip dies after the chips are diced without further testing. The marking of faulty chip dies may also be a cumulative process, e.g. in a multi patterning process a chip die is marked faulty once a sum of the misalignments reaches a certain threshold.

The wafer stage 2 and reticle stage 3 are arranged for holding and positioning the wafer 12 and reticle 13, respectively. Thereto the stages 2 and 3 typically comprise a holding means such as a clamping device or vacuum suction device. Furthermore, the stages 2 and 3 typically comprise positioning means such as a motor stage or other device capable of accurately displacing the respective stages. For accurate positioning, the said positioning means may use e.g. interferometry techniques or grid plate encoders such as known in the art.

The term wafer or semi-conductor wafer is known in the field of lithography and chip die manufacturing. A wafer is typically dimensioned as a disc of 700 micrometer thickness and a diameter of 200 or 300 mm, but also other sizes are possible. Standard device wafer dimensions can be found e.g. in the "SEMI M1 - Specifications for Polished Single Crystal Silicon Wafers". The wafer typically comprises a semi-conductor material such as silicon.

The illumination system 4 typically comprises refractive and/or reflective optics to shape radiation from the radiation source 5 into a uniform illumination pattern and project this illumination pattern onto the reticle 13. Depending on whether the system 1 is working in a scanning or stepper type mode, the illumination may cover part of or the whole the mask pattern 32, respectively. In a scanning mode the illumination system may e.g. illuminate and scan a narrow line over the mask pattern 32, e.g. by movement of the reticle relative to the scanning line. In a stepper mode, e.g. a whole mask pattern 32 may be illuminated at once. Also combinations of scanning/stepping modes may be possible.

The radiation source 5 may be comprised in the system 1 or separate there from. The radiation source may e.g. comprise an excimer or solid state laser, or a discharge- or laser-produced plasma for generating the desired radiation 15, typically around 193 nm (e.g. between 190 and 200 nm) for immersion lithography or around 13 nm (e.g. between 5 and 20 nm or lower) for EUV applications.

The projection system 6 typically comprises refractive and/or reflective optics to project part of or the whole mask pattern 32 illuminated by the illumination system 4. The projection system projects an image of the mask pattern 32 of the reticle 13 onto the wafer 12. This image may be demagnified, e.g. using a demagnification factor of four, the projected image may be four times smaller than the original mask pattern 32.

The position controller 7 may comprise any type of processor either dedicated or shared with other systems. The position controller 7 may include micro-processors, central processing units (CPUs), digital signal processors (DSPs), ASICs, or any other processor(s) or controller(s) such as digital optical devices, or analog electrical circuits that perform the same functions, and employ electronic techniques and architecture. The processor is typically under software control for example, and has or communicates with a memory which may be the memory device 10, storing the software and other data such as user preferences, parameters, calibration data, position data, and/or fluorescence intensity data.

The term "position sensor", as used herein, may refer to any sensor capable of measuring a position or alignment of the wafer, in this case by measuring a fluorescent signal that is a function of an overlap between an alignment marker on the wafer and a corresponding marker scan pattern projected on the wafer. The position sensor may also be referred to as a fluorescence sensor or more general an optical sensor. The position sensor 8 may comprise any suitable photo sensor or detector for detecting the fluorescent light 14. Examples may include active pixel sensors (e.g. CMOS), charge-coupled devices (CCD), photo resistors or light dependent resistors (LDR), photovoltaic cells, photodiodes, photomultiplier tubes, phototransistors, or combinations thereof. To filter out unwanted radiation 15 from the radiation source, the position sensor may comprise an integrated filter 11. Alternatively, the filter 11 may be separate or not required at all. E.g. the position sensor may comprise optical elements that only or mostly react to the fluorescent light 14 while being less sensitive to the radiation 15. It is to be appreciated that, a relatively simple detector may suffice for determining misalignment through detecting an amplitude of the fluorescence signal. This may have a further advantage that a larger bandwidth may be available for measurement and control, thus further contributing to the realization of real-time feedback control.

The feedback circuit 9 is arranged to interpret input Ss from the position sensor 8 and provide feedback Sf to the position controller 7. The feedback signal Sf may be an analog or digital signal, suitable as input to be interpreted by the position controller 7. The feedback circuit 9 may be any (programmable) device or circuit capable and arranged for performing this task. Whilst shown as a separate device, alternatively, the feedback circuit may be integrated into the position sensor 8, wherein the position sensor 8 or a feedback circuit therein converts the intensity of the fluorescent signal 14 into a suitable feedback signal Sf for the position controller 7. Feedback and input signals are preferably electrical signals, but also other types of signals such as optical signals are possible.

The memory device 10 may be any suitable type of memory where data are stored. Any medium known or developed that can store and/or transmit information suitable for use with a computer system may be used as a memory. The memory may also store application data as well as other desired data accessible by the position controller 7 and/or the feedback device 9 for configuring it to perform operational acts in accordance with the present systems and methods.

While currently shown as separate devices, the position sensor 8, the feedback device 9, the position controller 7 and the memory device 10 may all or partly be a portion of a single (fully or partially) integrated alignment system which it self may be partly or fully integrated into other parts of the chip die manufacturing system 1. Alternatively, instead of being integrated in a single device, parts of the shown devices may be distributed between multiple devices. Furthermore the system may comprise further components not currently shown, used in the typical operation of a chip die manufacturing. Not shown are e.g. parts of the system that may be used for developing the exposed chip die patterns such as known in the art.

With the term 'exposure radiation 15' is meant radiation that is used for exposing chip die patterns on the wafer. Typically, this exposing involves a photo-triggered reaction of a photoresist layer on the wafer. This reaction may e.g. change a solvability of the said photoresist to an etching material used in a subsequent development step. Typical frequencies of the exposure radiation include 193 nm for deep ultraviolet (DUV) applications such as used in immersion lithography and/or double patterning, or around 13.5 nm for extreme ultraviolet (EUV) applications. With the term 'patterned exposure radiation 15' is meant the exposure radiation 15 that is patterned according to a pattern of the mask and projected by the projection system 6 onto the wafer 12.

In the current embodiment the exposure radiation 15 is shown as transmitting through the various components such as the illumination system 4, reticle 13, reticle stage 3, and projection system 6, e.g. in accordance with a system 1 employing a transmissive reticle 13 and refractive optics such as lenses. In an alternative embodiment, the radiation may be reflected off some or all of the components. The reticle 13 may be thus of a transmissive type, comprising a pattern of transmissive and non- transmissive surfaces, or of a reflective type, e.g. comprising a pattern of reflecting and non-reflecting surfaces. For example, in a typical EUV system, the illumination system 4 and projection system 6 comprise reflective optics such as curved mirrors for shaping and reflecting the exposure radiation 15.

Fluorescence is the emission of light by a substance that has absorbed light or other electromagnetic radiation of a different wavelength. While typically, the emitted light of the fluorescent signal 14 has a longer wavelength, than the absorbed exposure radiation 15, alternatively, e.g. when the absorbed electromagnetic exposure radiation 15 is intense, such as may be the case in a lithographic apparatus, the fluorescent signal 14 may have a shorter wavelength than the absorbed exposure radiation 15, e.g. due to two photon absorption. The fluorescence absorption and emission spectra may be governed by (molecular) states of the fluorescent molecule or fluorophore and transitions there between. The efficiency of a fluorescence process may be given by the quantum yield of that process. It may be defined as the ratio of the number of photons emitted to the number of photons absorbed. While, the maximum fluorescence quantum yield is typically 1.0 (100%), wherein every photon absorbed results in a photon emitted, substances with quantum yields of 0.10 are still considered quite fluorescent. Substances for use as fluorescent markers in the currently disclosed systems and methods, preferably have a fluorescence efficiency or quantum yield for conversion of the exposure radiation into fluorescent light that is at least 0.10, more preferably 0.50 or higher, e.g. 0.7 - 1.0. In particular, the higher the efficiency, the easier will be the detection of the fluorescent response.

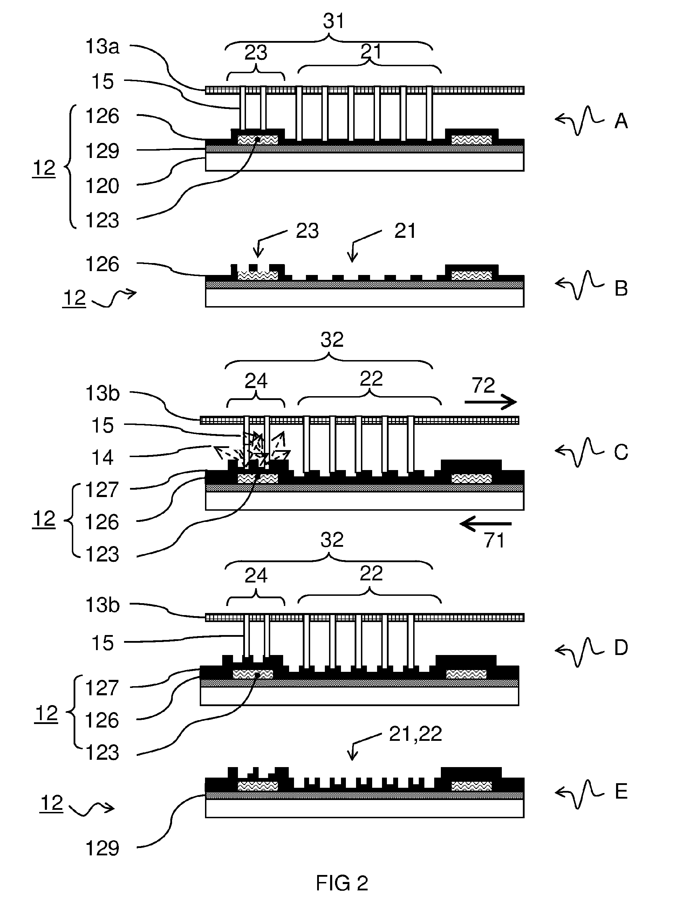

FIG 2 shows an embodiment for a method of position control in a chip die manufacturing system wherein an alignment mark 23 is produced on a wafer together with a first chip die pattern 21 and subsequently used for alignment of a second chip die pattern 22. Prior to the first exposure step A, the wafer 12 comprises a substrate layer 120, an optional sacrificial layer 129, and a fluorescent material 123. The substrate is covered by a (photo)resist layer 126. Also additional layers may be provided that are not shown in the current illustration such as a bottom anti reflection coating (BARC) to prevent reflection from the substrate 120 or sacrificial layer 129 and/or a topcoat, e.g. to protect the resist layer 126 from fluid when using immersion lithography.

In a first exposure step A, the first mask pattern 31 of the first reticle 13a is projected onto the resist layer 126 with exposure radiation 15. The exposure causes a reaction in the resist layer 126 on the irradiated positions. The irradiated pattern is subsequently developed e.g. by selective etching of the irradiated parts of the resist layer 126.

This results in a patterned resist layer such as shown in step B. Because the mask pattern 31 comprises both the first chip die pattern 21 and the pattern for the alignment mark 23, both patterns are projected with a fixed relative location, which may be determined by the projection system. This may enhance the accuracy of the alignment process that follows.

Steps A and B thus illustrate an embodiment wherein the fluorescent alignment mark 23 is formed on the wafer 12 by means of a photolithographic process, wherein the alignment mark 23 is produced by holding, optionally scanning, and positioning a first reticle 13a comprising a first mask pattern 31 comprising a pattern of the alignment mark 23; irradiating the first mask pattern 31 with exposure radiation 15 from the radiation source 5; projecting an image of the first mask pattern 31 onto the wafer 12; and developing the wafer 12 to produce the alignment mark 23 comprising the patterned material 123 having a fluorescent frequency-shifted response to the radiation 15.

In an embodiment, the first mask pattern 31 further comprises another chip die pattern 21 that forms a multi patterning pair with the chip die pattern 22 of a subsequent projection step C,D, wherein the another chip die pattern 21 is projected simultaneously with the pattern of the alignment mask 23 as a first step in a multi patterning process.

In a further embodiment, the pattern of the alignment mark 23 is projected in step A on a part of the wafer 12 comprising the material 123 having a fluorescent frequency-shifted response to the radiation 15.

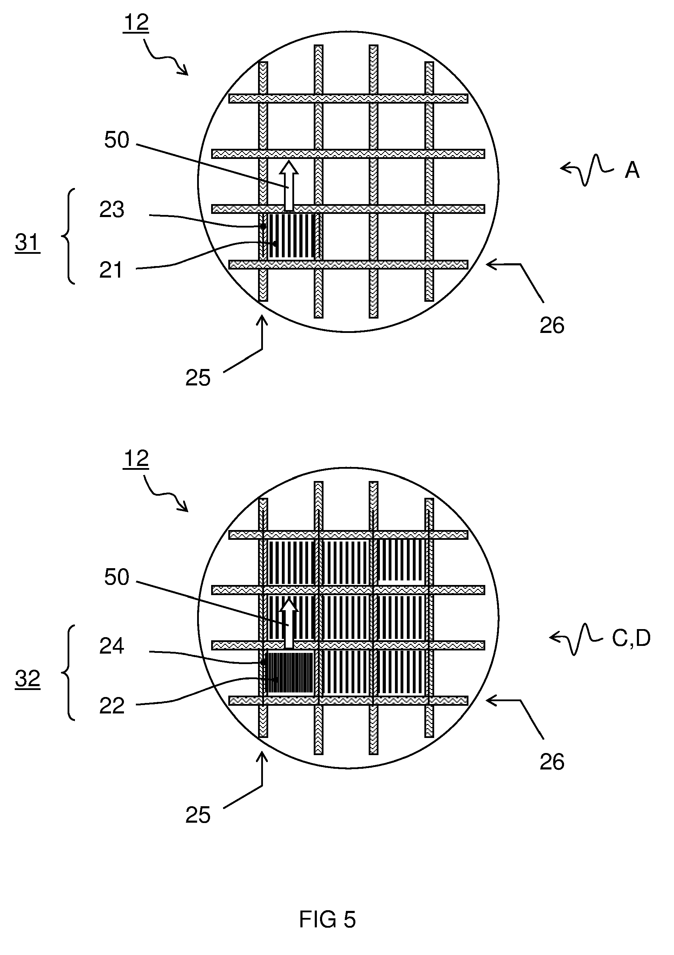

In a further embodiment, the said part of the wafer 12 comprises scribe lines on the wafer 12 between positions where the chip die patterns 21,22 are to be projected (see e.g. FIG 5).

In a further embodiment, the material 123 having a fluorescent frequency-shifted response to the radiation 15 is applied to the said part of the wafer 12 by a printing step before the projecting of the pattern of the alignment mark 23.

Steps C and D illustrate a method for position control in a chip die manufacturing system. This method comprises holding and positioning the wafer 12 as well as holding and positioning a reticle 13b comprising a mask pattern 32. The mask pattern 32 comprises a chip die pattern 22; The mask pattern 32 is irradiated with exposure radiation 15 from a radiation source (e.g. shown in FIG 1); an image of the mask pattern 32 is projected onto the wafer 12; a position of the wafer stage 3 and/or the reticle stage 2 is controlled as illustrated by the arrows 71 and 72; a position of the wafer 12 is detected by means of an alignment mark 23 on the wafer 12; and feedback of the detected position of the wafer 12 is provided for adjusting the position of the wafer 12 and/or reticle 13 as a function of said feedback.

The alignment mark 23 comprises a material 123 having a fluorescent frequency-shifted response to the exposure radiation 15 of the radiation source. During the projecting of the chip die pattern 22 a fluorescent signal 14, emanating from parts of the alignment mark 23 irradiated by exposure radiation 15 of the radiation source 5 by the marker scan pattern 24 is detected, e.g. by a position sensor. This fluorescent signal 14 provides the system with real-time feedback for adjusting a position of the wafer 12 and/or the reticle 13 during or directly after the projecting of the chip die pattern 25 as a function of said real-time feedback.

Step C illustrates that on positions where the exposure radiation 15 impinges on non-covered parts of the fluorescent material 123, a response resulting in fluorescent 14 may occur. The fluorescent signal 14 may be detected e.g. by the position sensor discussed in FIG 1 and used for real-time feedback to the position controller. The position controller may move the wafer 12 and/or the reticle 13b as a function of the fluorescence signal registered by the position sensor and feedback circuit.

Thereto, the position controller may e.g. employ a minimization algorithm seeking for the lowest fluorescence intensity by moving the wafer 12 and/or the reticle 13b in different directions. In the current example, the algorithm may determine that by moving the wafer 12 in direction 71 and/or by moving the reticle 13b in direction 72, the amount of fluorescent signal 14 decreases. The position controller may continue minimizing until a minimum value is reached and/or the fluorescence signal gets below a threshold value. This occurs in the current example when the exposure radiation 15 impinges on the resist layer 126 defining the marker patter 23 that was formed in steps A and B. Because the marker scan pattern 24 has a fixed relation with respect to the second chip die pattern 22, and the alignment mark has a fixed relation to the first chip die pattern 21, the proper alignment of the marker scan pattern 25 with respect to the alignment marker 23 means that also the second chip die pattern 22 is properly aligned with respect to the first chip die pattern. This is the case in step B wherein in the current example the second chip die pattern 22 irradiates an interstitial pattern between the first chip die pattern created in steps A and B.

It is to be appreciated that the chip die pattern 22 projected in steps C and D may thus be a second chip die pattern that is different from the first chip die pattern 21 projected in step A, to provide complementing patterns e.g. in a double patterning process. The complementing pattern may increase the attainable resolution of features such as lines on the wafer. Alternatively or in combination, the first and second pattern may also correspond to components of the chip die that require a different development process, e.g. for depositing different materials on the same wafer.

After a second development step, the final pattern as shown in step E may comprise e.g. a linear or non-linear superposition of the chip die patterns 21 and 22. This final pattern may subsequently be transferred by a further development step (not shown) e.g. into the sacrificial layer 129 to form the final chip die pattern.

While in the current embodiment, two exposure steps A and C/D are shown with a first mask pattern 31 and a second mask pattern 32, this method may also be restricted to just the steps C and D, e.g. in case the alignment mark 23 is already present on the wafer created previously by means of another technique such as printing, pressing, or any other technique. Alternatively, the process may also be expanded to more exposure steps than shown. E.g. a fluorescent alignment marker may be deposited in a first step together with a first pattern, and in subsequent exposure steps this alignment mark may be used to align the subsequent patterns, e.g. in a triple patterning process or more. It may also be possible, e.g. to deposit two sets of alignment marks in the first exposure step wherein the first and second of these sets is used to align the second and third exposure steps, respectively. Also, while the current example may comprise steps consistent with a so-called Litho-Etch-Litho-Etch (LELE) process, it is to be appreciated that also other sequences of processes may be possible in combination with the currently disclosed method of alignment wherein a chip die pattern is aligned with real-time feedback onto a wafer comprising a fluorescent marker using a marker scan pattern that is part of the same mask pattern as the said chip die pattern. Other such schemes that may benefit include e.g. Litho-Etch-Litho-Freeze (LELF) or the sidewall spacer approach, also called SADP.

As shown in step B, the fluorescent alignment mark 23 may be formed by a patterned material, e.g. resist 126, on top of the fluorescent material 123 that reflects or absorbs incoming radiation at specific positions of the pattern. Alternatively, the material 123 itself may be patterned, e.g. selectively etched away. It may e.g. be possible to apply a fluorescent material to parts of the wafer, which material itself acts as a photo resist. Between steps B and C a second resist layer 127 may be applied to the wafer. In the current example, e.g. the second resist layer 127 may be transparent to the fluorescent light 14, while the first resist layer 126 is opaque to the fluorescent light 14. This way, when exposure radiation 15 leaks impinges on the second resist and the fluorescent material 123 below, the fluorescent signal 14 that is emitted as a response, may be transmitted through the second resist layer 127, while being blocked by the first resist layer 126. Alternatively, no second resist layer 127 is applied, and the second chip die pattern 22 is simply projected in the same resist layer 126 as already exposed and developed in steps A and B.

In the current embodiment the resist layer 126 comprises a positive photo resist, meaning that the portion of the photo resist that is exposed to light becomes soluble to the photo resist developer or etchant while the portion of the photo resist that is unexposed remains insoluble to the photo resist developer. This means that, in the development step, irradiated parts may be etched away while non radiated parts remain.

Alternatively, a negative photo resist may be used wherein irradiated parts remain while non radiated parts are etched away. It is noted that the marker pattern 23 and/or the marker scan pattern 24 may need to be adjusted accordingly depending on whether the alignment marker produced in steps A and B will fluoresce on positions that were initially exposed by the exposure radiation 15 from the marker pattern 23 or on positions that were initially not exposed by said radiation. E.g. when using a negative resist, the marker pattern 23 may leave a fluorescent alignment marker with a pattern that is negative with respect to transmissive parts of the pattern 23 on the reticle 13a. Accordingly, the marker scan pattern 24 on the second reticle 13b may be similar to the marker pattern 23, i.e. comprise a similar transmission pattern, such that when the two patterns the exposure radiation 15 will impinge on the overlap a minimal fluorescence signal will be detected.

FIG 3 shows an example of a first mask pattern 31 and a second mask pattern 32. The first mask pattern 31 comprises a first chip die pattern 21 surrounded by a pattern of alignment marks 23. The second mask pattern 32 comprises a second chip die pattern 22 surrounded by a marker scan pattern 24. The second chip die pattern 22 may e.g. complement the first chip die pattern 21 in a double patterning process. The marker scan pattern 24 forms a matched pair with the alignment mark 23, i.e. the marker scan pattern 24 is matched to the alignment mark such that when the corresponding chip die patterns 21 and 22 are well aligned, a minimal fluorescence occurs. A minimal fluorescence signal need not be zero, e. g. if in an optimal alignment, the marker scan pattern still overlaps part of the alignment marker. Alternatively, the patterns 23 and 24 may be matched such that a maximal fluorescence occurs when the chip die patterns 21 and 22 are properly aligned.

Preferably, alignment mark pattern 23 or overlay markers are put in the scribe lane, i.e. the space between chip die patterns. This way the chip design may be independent from the alignment markers. Alternatively, the alignment markers 23 may be placed between intermittently between the chip die pattern, e.g. on places where no chip die components are placed. In yet another embodiment, the chip die pattern 21 may itself form the fluorescent marker, e.g. using a fluorescent resist or sacrificial layer that may be formed in a first expose and etching step.

In a typical wafer stepper, the reticle is exposed in a scanning fashion, using an expose beam that is in one direction significantly smaller than the reticle length. Consequently, a series of markers in the scribe lane may be exposed consecutively. When the markers are separated by a distance that is larger than the expose beam with, cross-talk between subsequent markers may be acceptable. For example, in the design of an alignment marker pattern the order of the overlay directions that are to be monitored may be selected by firstly selecting the marker patterns for both expose steps, secondly leaving sufficient separation between subsequent marker sets and thirdly, selecting their relative (shifted) position when projected at the wafer.

In an embodiment, prior to a first patterning step, a fluorescent dye is applied to areas of the wafer, e.g. on the scribe line area between the dies. This dye is converted into an alignment marker during a first exposure step. Preferably, the fluorescent alignment marker comprises lines that are at least 50 nm wide to provide a sufficient overlap area with a corresponding marker scan pattern. A length of the lines is preferably at least twice the width, e.g. 100 nm or more. An example of an alignment marker may be a short line, typically 100 nm wide and 1 µm long.

During a second exposure step a marker scan pattern is irradiated just beside the alignment marker. When the alignment is off, light of the marker scan pattern may fall onto the alignment marker. Because this alignment marker comprises fluorescent material, the marker may emit fluorescent light. The intensity of this light may be approximately proportional to the alignment error, while the wavelength differs from the exposure radiation. This has an advantage that the fluorescent light emitted by the markers may be easily separated from the background radiation. In a further embodiment, employing four markers for the alignment error in positive and negative directions of the X-Y plane, the overlay may be fully characterized. Parallelizing may be intrinsically simple in lithographic processes. By using many markers, a strong signal may be generated. A quite straightforward processing of these signals may provide the overlay status. The simplicity of the signal and the numerical processing thereof may aid in the real-time measurement and correction of alignment errors.

FIG 4 shows steps of aligning the alignment mark and marker scan pattern of FIG 3. The steps C and D shown correspond to similar steps illustrated in FIG 2. In particular in step C the marker scan pattern 24 is misaligned with respect to the alignment mark pattern 23. As shown, on positions where the patterns 23 and 24 overlap, the fluorescent material comprised in the alignment markers 23 may emit a fluorescence signal 14. The wafer and or reticle may be moved with respect to each other e.g. in a direction 71 to minimize the amount of fluorescent light 14 until a situation such as shown in step D is reached wherein the first and second chip die patterns 21 and 22 are properly aligned.

To monitor perpendicular X and Y directions, the alignment marker pattern may comprise a combination of differently oriented lines or other patterns. In the current example, alignment markers 23x and corresponding marker scan patterns 24x are directed in the Y direction to monitor misalignment in the X direction. Similarly, alignment markers 23y and corresponding marker scan patterns 24y are directed in the X direction to monitor misalignment in the Y direction. The combination of these patterns has an advantage that the misalignment in the X and Y directions may be monitored and minimized more independently. Accordingly in an embodiment there is provided a semiconductor wafer (e.g. shown in FIG 5), wherein a marker pattern 23x,23y is applied to a fluorescent material on the wafer, the marker pattern comprising a pattern of parallel lines in a first direction X and parallel lines in a second direction Y, perpendicular to the first direction X for the purpose of tracking an alignment of the marker pattern 23x, 23y in the two perpendicular directions X, Y with a corresponding marker scan pattern 24x, 24y.

In the current example, the alignment markers 23x and 23y and marker scan patterns 24x and 24y are similar in shape and size on the wafer. The magnitude of the fluorescent signal is functionally related to the overlay error between the respective alignment markers and marker scan patterns. This functional relationship is preferably a proportionality relationship, but also other functional relationships may be possible. Almost any combination of shapes and sizes for alignment markers and marker scan patterns may be used, as long as preferably there exist a known or measurably functional relationship between the amount of overlay between the patterns 23 and 24 and the resulting fluorescent signal 14. E.g. the amount of fluorescent signal may also be inversely related to the misalignment of the wafer.

In an embodiment, one set of alignment markers and marker scan patterns is mirrored by another set of alignment markers and marker scan patterns such that misalignments both in the positive and negative direction may be monitored. An example of this is indicated as mirrored pair 23m, wherein a relative positioning of the alignment marker and the marker scan pattern is reversed, e.g. in a proper alignment position (step D) the marker and scan patterns are arranged such that in one of the mirrored pair 23m, the marker scan pattern 24x is just right of the alignment marker 23x while in the other of the pair, the marker scan pattern 24x is just left of the alignment marker 23x. Thus while one set of markers may be used to monitor shifts in the +X direction, another set of markers may be used to monitor shifts in the - X direction. This may be done by e.g. in the first set placing the marker scan pattern on the -X direction of the alignment marker lines while in the second set placing them on the +X direction or vice versa depending if a minimum or maximum fluorescence signal is desired. The same may be done for the +Y and -Y directions. Accordingly, there is provided a semiconductor wafer, wherein a marker pattern 23x is applied to a fluorescent material 123 on the wafer, the marker pattern 23x comprising a plurality of mirrored pairs 23m for the purpose of tracking an alignment of the marker pattern 23x with a corresponding marker scan pattern 24x in two opposite directions +X and-X.

It is noted that the fluorescent signal 14 may be increased by increasing the number of markers 23x, 23y, or at least the number of edges of the markers 23x, 23y that may overlap with a corresponding marker scan pattern 24x, 24y.

FIG 5 shows a process of applying a first and second pattern to a wafer 12. In a first exposure step A, a resist layer on the wafer 12 is exposed to the first chip die pattern 21. At the same time also the alignment mark pattern 23 is applied in the scribe lines 25 and 26 between the chip dies. Preferably, the scribe lines 25 and 26 comprise thereto a fluorescent material that is developed in a subsequent development step to form the fluorescent marker pattern.

In a second exposure step C, D, the resist layer on the wafer 12, patterned by the previous exposure step A, is exposed to a second chip die pattern 22 while the applied alignment mark pattern 23 is exposed to a matching marker scan pattern 24. These patterns 21-24 are patterned and positioned relatively with respect to each other such that when the patterns 23 and 24 do not overlap, as determined by the minimum of fluorescent response, the patterns 21 and 22 are properly aligned. An example of such patterns was provided e.g. in FIG 3.

Whilst in the current example, both horizontal and vertical scribe lines are used, alternatively, e.g. only the scribe lines 25 along a scanning direction 50 are provided with the alignment mark pattern 23. This way, at least while scanning the alignment marks 23 during a scanning exposure step, a suitable fluorescent response may be generated along all parts of the scanning trajectory 50.

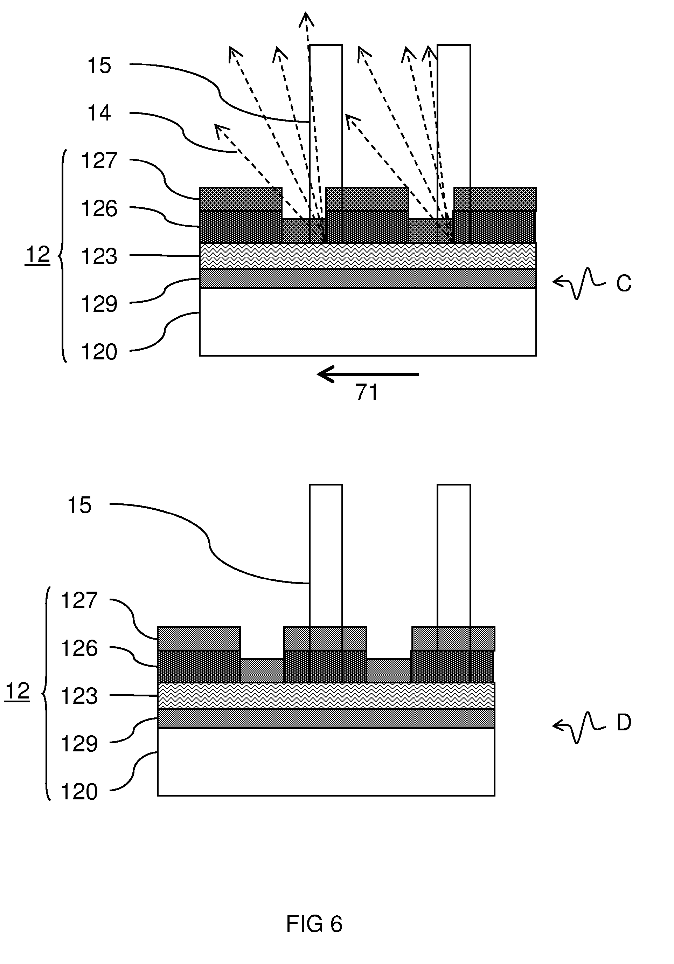

FIG 6 shows a detail of an embodiment of the alignment mark being positioned according to the method of FIG 2. Only a part of a cross-section of the wafer 12 comprising the fluorescent material 123 is shown. The wafer comprises a substrate layer 120, a sacrificial layer 129, fluorescent material 123, a patterned first resist layer 126 and a second resist layer 127. In this embodiment, the alignment mark is formed by the patterned resist layer 126 on top of the fluorescent material 123. To provide a position dependent response to the exposure radiation 15, e.g. the (developed) first resist layer 126 is opaque to the exposure radiation 15 from the radiation source and/or the fluorescent signal 14. Alternative to using two resist layers, the same resist layer 126 is exposed twice and no second resist layer is used.

In step C, it is illustrated that when the exposure radiation 15 from the exposure beam impinges on exposed parts of the fluorescent material 123, a fluorescent signal 14 may be emitted as a response. The intensity of this fluorescent signal 14 may be monitored to provide feedback to a reposition the wafer, e.g. in a direction 71, wherein the intensity of the fluorescent signal 14 decreases.

In step D, a properly aligned wafer is shown, wherein the marker scan pattern formed by the patterned exposure radiation 15 impinges on the covered parts of the fluorescent material such that no or only a minimal fluorescent response is caused.

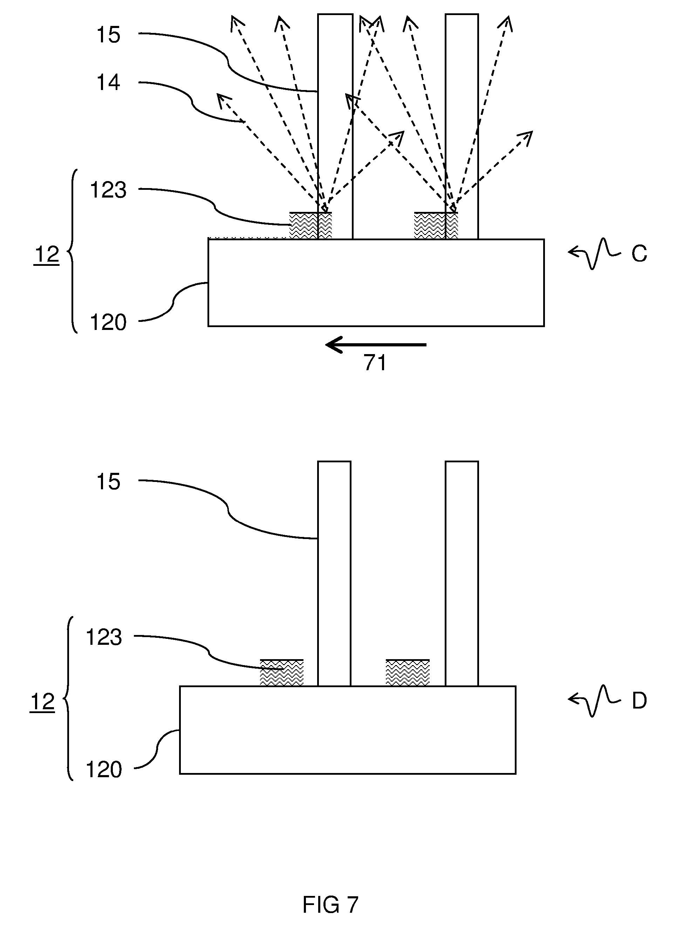

FIG 7 shows another embodiment of the alignment mark being positioned according to the method of FIG 2. In this embodiment, the alignment marker is formed on the wafer substrate 120 by a pattern of fluorescent material 123. This pattern may be created with any known lithographic technique, e.g. the fluorescent material may be also a photo resist material that is exposed and developed a prior lithographic step.

In step C, it is illustrated that when the exposure radiation 15 impinges on the fluorescent material 123, a fluorescent signal 14 may be emitted as a response. The fluorescent signal 14 may be minimized e.g. by moving the substrate 12 in direction 71. This may lead to the situation such as shown in step D, wherein the exposure radiation 15 impinges in between the fluorescent material 123 and no or a minimal fluorescent response is observed.

While the fluorescent signal 14 is currently shown as scattering in random directions, alternatively, the fluorescent signal 14 is emitted in a preferential direction, such as in a direction of the position detector. This has an advantage that a higher intensity fluorescent signal 14 may be recorded.

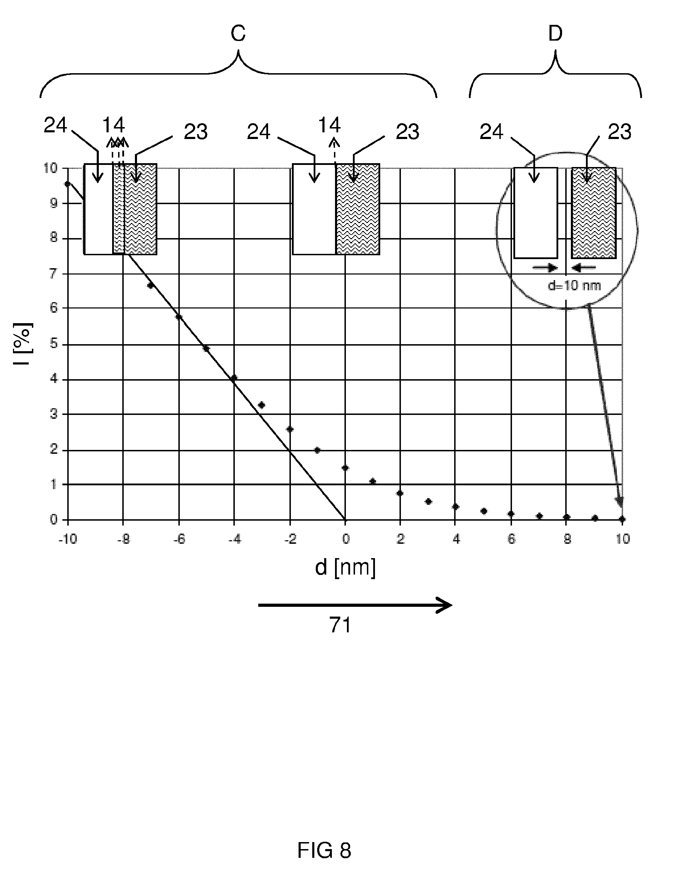

FIG 8 shows a graph of fluorescence intensity I of fluorescent signal 14 as a function of overlap d between an alignment mark 23 and a marker scan pattern 24 as predicted by a photon budget model, assuming realistic attributes of scanner and marker material. The maximum of the intensity occurs when the marker and the patterned beam have full overlap (100%), i.e. at an overlay error approximately equal to the marker size, which in practice will be hundreds of nanometers up to microns or larger.

It is to be appreciated that by monitoring the fluorescence intensity I, the overlap d may be determined. When aligning in regime C, the overlap d may be reduced by moving the wafer stage in direction 71 such that the intensity I decreases until a minimum or threshold intensity is achieved in regime D. By constructing the alignment marker 23 and marker scan pattern such that a minimal overlap d corresponds to an optimal alignment, the wafer may be aligned as a function of the fluorescence intensity I.

It is noted that the intensity I may be a non-linear function of the overlap d, e.g. because the alignment marker 23 and/or the marker scan pattern 24 may not have sharply defined edges. In an embodiment, prior to the actual full die exposure process, the functional dependence of the intensity I of the fluorescence signal 14 on the position 71 of the wafer stage may be established and e.g. calibrated to a linear dependence.

An example calibration procedure may be as follows:
1. Load wafer with finished fluorescent marker in previous layer in stepper
2. Load reticle for the present expose layer in the stepper
3. For each direction (e.g. -X, +X, -Y and +Y) do the following:
   a. Move reticle stage such that the expose beam is patterned by the in-line-overlay pattern
   b. Move the wafer stage such that the in-line-overlay marker is very close to the target position
   c. Scan the wafer stage such that the expose beam moves over the marker and record the fluorescence signal. The scan range should cover no-overlap to full-overlap of the expose pattern with the marker.
   d. For improved statistics, repeat step a-c, until a reproducible and reliable calibration curve is obtained.
   e. Store the calibration curve for each direction
4. Verify overlay calibration curve for:
   a. static reticle position control (as under 3a) at different wafer scan speeds
   b. dynamic reticle position control, by scanning wafer and reticle stage simultaneously

While it is currently shown that the magnitude of the fluorescent signal 14 is higher for higher degrees of misalignment, alternatively this may be reversed, i.e. the lower the fluorescent signal the better the alignment of the chip die pattern. In an embodiment, the fluorescent signal may also attain a specific value when optimal alignment is achieved, which value may be a minimum or maximum fluorescence signal or any value in between.

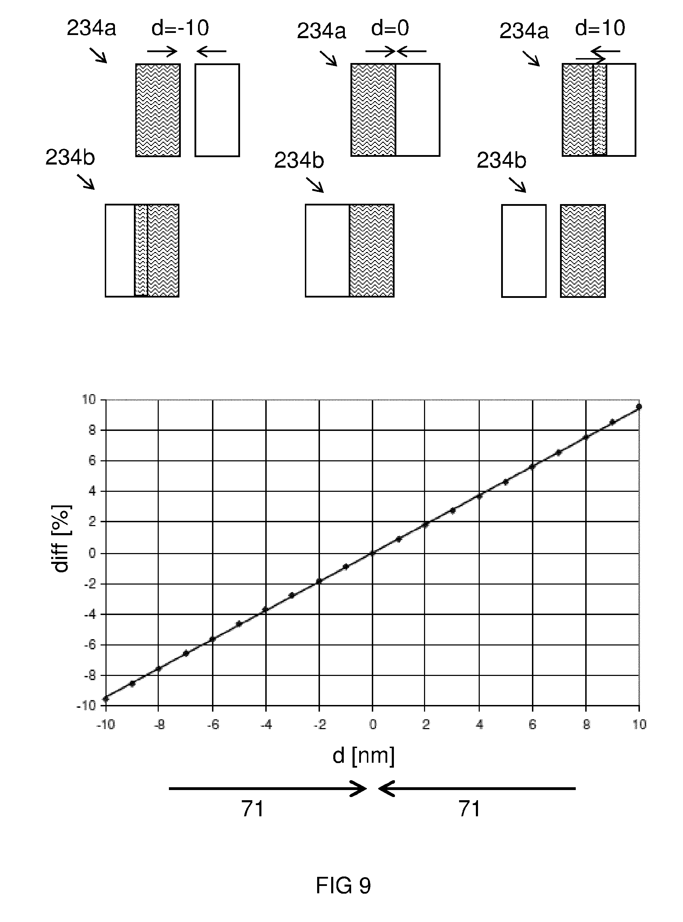

FIG 9 shows a graph of fluorescence intensity difference between a pair of mirrored alignment marks as predicted by a photon budget model. The mirrored pair is constructed to monitor the same coordinate in opposite direction such that an overlay error in either direction results in an increased overlap between the fluorescent marker pattern and the marker scan pattern expose beam. When the mirrored pair of alignment marks is monitored independently, a difference signal between the received fluorescence intensities may be constructed. As shown in the figure, the difference signal may be more linear than the separated signals. It is noted that the slope of the curve, may determine the resolution of the positioning.

From left to right it is shown that while shifting the marker scan pattern over the mirrored pair of markers 234a and 234b, the overlap of the first marker 234a increases while the overlap of the second marker 234b decreases. Around d=0, the overlap of the markers is exactly balanced.

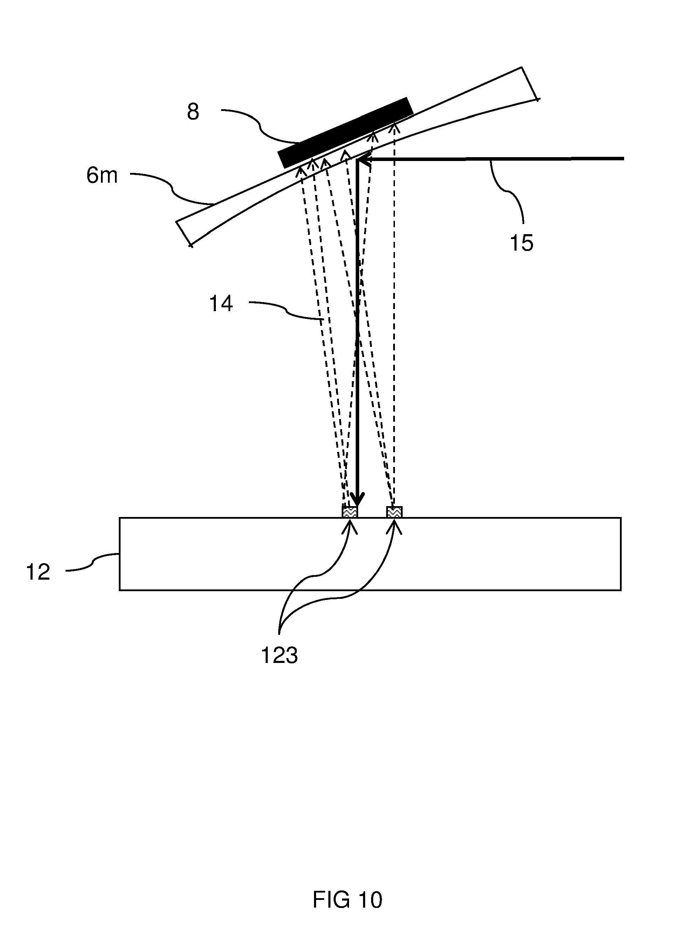

FIG 10 shows an embodiment wherein a position sensor 8 is placed behind a dichroic mirror 6m that is part of the projection system. The mirror 6m reflects exposure radiation 15 used for exposure radiation, while transmitting the fluorescent signal 14 emitted from the fluorescent material 123 on the wafer 12. This configuration has an advantage that it is relatively easy to implement, e.g. by modifying a conventionally used mirror, e.g. in a catadioptric system, with a dichroic coating and/or a substrate that is transparent to the fluorescent signal 14. Alternative to providing a separate sensor 8 behind the mirror, the sensor, or at least a radiation sensitive surface thereof may also be directly attached, e.g. coated onto the back of the mirror 6m.

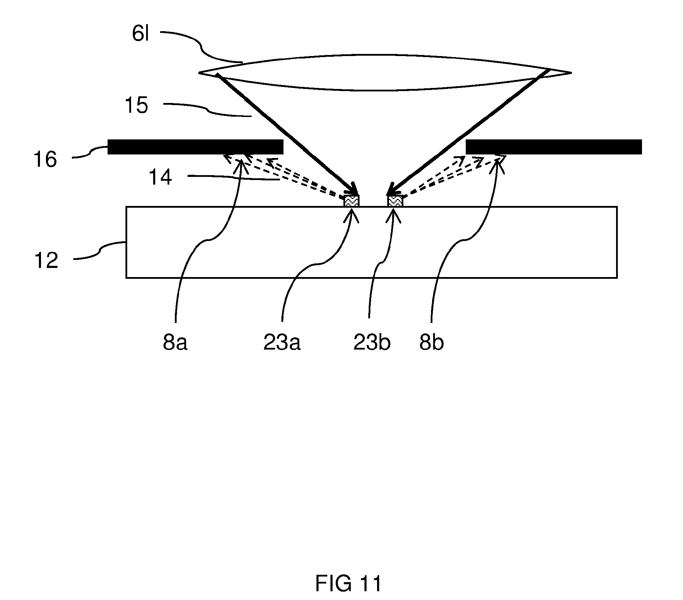

FIG 11 shows an embodiment wherein position sensors 8a and 8b are integrated into an immersion hood 16. Immersion hoods for lithography are known as such in the art, e.g. from U.S. 2007/0258060. The immersion hood may be used, e.g. to hold a fluid such as water in an immersion lithographic process, e.g. using as exposure radiation 15, deep ultraviolet light of 193 nm. In use, exposure radiation 15 is focused by lens 61 of the projection system onto the wafer 12. Fluorescent material of the alignment markers 23a and 23b may emit a fluorescent signal 14 that is detected by the position sensors 8a and 8b. In an embodiment, the light from the markers 23a and 23b is measured separately by the sensors 8a and 8b, respectively. This may be advantageous, e.g. in a further embodiment, wherein markers 23a in the left scribe lane form a mirrored pair with markers 23b in the right scribe lane e.g. for monitoring a coordinate of the wafer in two directions. Alternatively, e.g. the markers 23a and 23b may correspond to different coordinates, e.g. X and Y, of the wafer. Also combinations are possible, e.g. with four surrounding scribe lanes and four corresponding sensors, e.g. +X, -X, +Y, and -Y coordinates may be monitored separately.

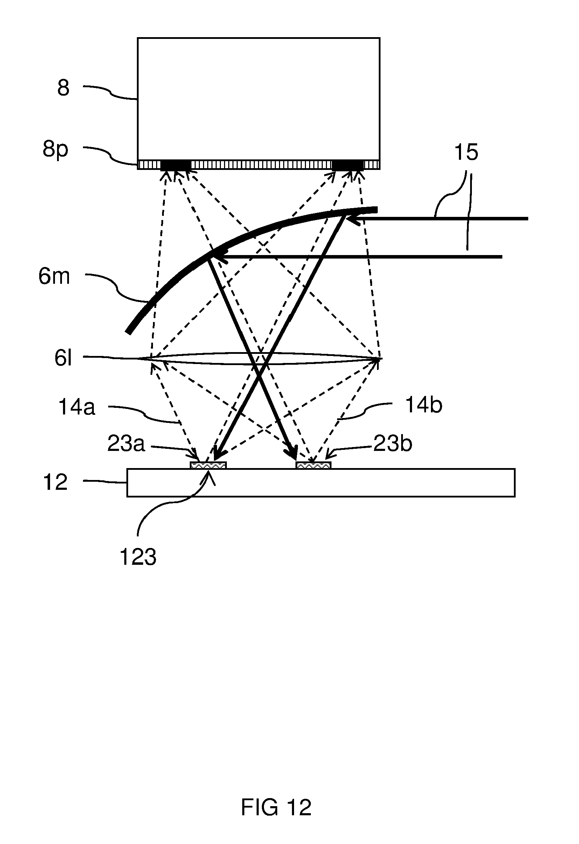

FIG 12 shows an embodiment of a position sensor 8 comprising a pixel array 8p for spatially distinguishing between different markers 23a, 23b on the wafer 12. In use, exposure radiation 15 for exposing the chip die pattern is reflected of dichroic mirror 6m, transmitted by lens 61, and impinges on the fluorescent material 123 of the markers 23a and 23b. As a result, fluorescent signals 14a and 14b may be emitted by the markers 23a and 23b, respectively, when the chip die pattern is misaligned. These fluorescent signals 14a and 14b are collected by the lens 61 which is also used for projecting the chip die pattern, and imaged onto the pixel array 8p of the position sensor 8. Thereto pixel array 8p is arranged with respect to the lens 61 and markers 23a and 23b such that an object plane coinciding with the wafer 12 surface is imaged in a plane coinciding with the pixel array 61. Also the dichroic mirror 6m is arranged to reflect exposure radiation 15 for exposing the chip die pattern, while transmitting the radiation of the fluorescent signal 14.

Since light from the markers 23a and 23b is thus separately imaged, it may also be measured independently, e.g. by separate pixels, and used e.g. to measure a coordinate in opposite directions or measure multiple coordinates independently or other combinations such as discussed above. Alternative to a pixel array 8p, also multiple detectors or detection surfaces may be used to form the position detector.

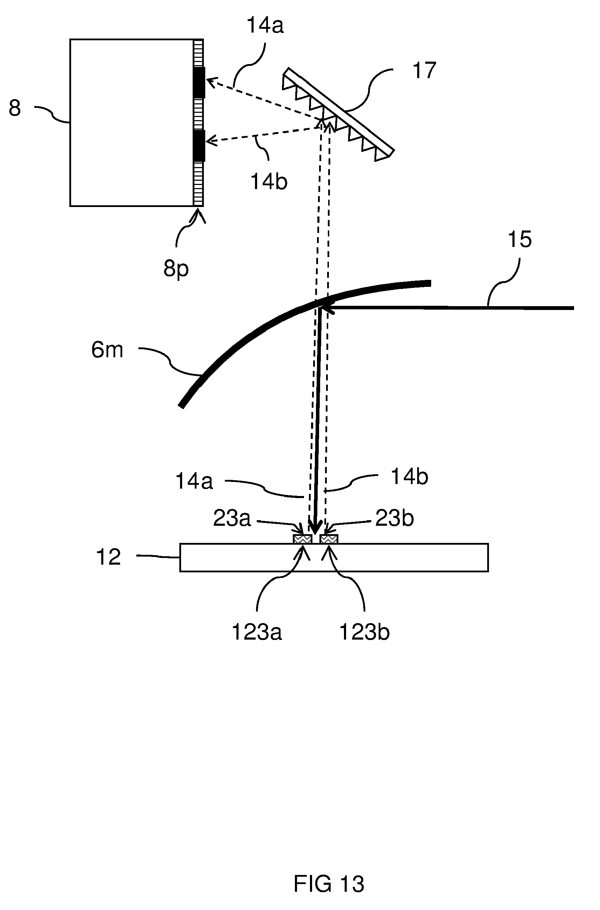

FIG 13 shows another embodiment of a position sensor 8 comprising a pixel array 8p. In this embodiment, the fluorescent material on the wafer comprises two or more substances 123a and 123b with a distinct fluorescence emission spectrum 14a and 14b, respectively. In use, exposure radiation 15 for exposing the chip die patterns on the wafer reflects of dichroic mirror 6m and impinges the alignment markers 23a and 23b comprising the substances 123a and 123b, respectively. As a result, the substance 123a and 123b may emit fluorescent signals 14a and 14b. The substances 123a and 123b are chosen such that each fluorescent signal has a distinct fluorescence spectrum, i.e. the two or more fluorescence spectra may be disentangled. The dichroic mirror 6m comprises a coating and substrate material such that at least some of the frequencies of signals 14a and 14b are transmitted through the mirror 6m. In the current embodiment, the signals 14a and 14b each comprise a different principal or mean frequency such that these signals may be angularly dispersed by grating 17 and imaged onto pixel array 8p of the position sensor 8.

In an embodiment, the fluorescent material comprises quantum dots with an absorption at a frequency of the (patterned) exposure radiation 15 and a fluorescence at a frequency that is shifted relative to that of the exposure radiation 15. In a further embodiment, wherein two or more fluorescent signals 14a and 14b are desired, the fluorescent substances 123a and 123b may comprise quantum dots of different sizes such that their fluorescence spectra are different. Alternatively, other fluorescent materials are used with an absorption at the frequency of the exposure radiation and differing fluorescence frequencies.

Alternative to using a grating 17, also one or more additional dichroic mirrors may be used each reflecting one of the fluorescent signals while transmitting the others. Each of these reflections may then be directed to a separate sensor element or pixel comprised in the position sensor.

The currently disclosed embodiment thus uses a semiconductor wafer comprising two or more fluorescent materials to make up the alignment markers. Accordingly, in an embodiment there is provided a semiconductor wafer 12 for use in a lithographic apparatus. The wafer 12 comprises a fluorescent material having a fluorescent frequency-shifted response to the exposure radiation 15 for exposing chip die patterns onto the wafer 12 in the said lithographic apparatus. Typically, exposure radiation 15 is in a frequency range around 193 nm for deep ultraviolet (DUV) applications, or around 13.5 nm for extreme ultraviolet (EUV) applications. The absorption spectrum of the said fluorescent material preferably has a significant absorbance of at least 0.1, preferably 1 or higher, at the said frequency ranges.

In a further embodiment the fluorescent material comprises two or more substances 123a, 123b with a distinct fluorescence spectrum 14a, 14b, i.e. the emission spectrum of the first substance 123a is substantially different from the emission spectrum of the second or further substance 123b such that these spectra 14a, 14b may be deconvolved and/or its components distinguished between the different substances 123a, 123b. For example, a principal or main fluorescence frequency may be shifted from one substance 123a to the next 123b. Preferably, all substances 123a, 123b have a significant absorption at the frequency of the exposure radiation 15, such that all the substances may emit fluorescent radiation 14a or 14b that can be detected by the position detector 8.

A wafer with fluorescent markers may be produced, e.g. by first applying the fluorescent materials on different (scribe) lanes along the trajectory where the chip dies are to be projected. The material may be applied by a printing technique, e.g. inkjet printing. Subsequently, a resist may be applied to the said wafer with the two or more fluorescent materials applied and this resist may be exposed to the pattern for the alignment marks 23a and 23b which may be developed for forming the fluorescent markers. Also other techniques may be possible for applying the fluorescent material in an alignment marker pattern. E.g. in an alternative method, a pattern of holes is first applied to the wafer which holes are subsequently filled by a printing technique to form the fluorescent markers.

It is noted that the chromatic separation of markers, discussed with FIG 13, may also be combined with the spatial separation of markers discussed with FIG 12. E.g. markers from a first location indicate he +X and - X misalignment with two different colors while differently colored markers from a second location indicated +Y and -Y misalignment. Also any other combination of colors and locations is possible. It is to be appreciated that the chromatic and/or spatial distinction between markers may increase the amount of information that may be provided to the position sensor. In stead of or in addition to relaying information about the direction of the misalignment, e. g. also a further measure for the severity of the misalignment may be relayed. E.g. a different color may be used to indicate when the pattern is more severely misaligned. Also other types of information may be relayed by suitably chosen markers, e.g. about a misalignment due to a rotation or twisting of the wafer with respect to the exposure pattern.

The above embodiments have disclosed a method and the involved instrumentation to measure and/or control the overlay in a lithographic process real-time, i.e. in-line. The overlay between the die-under-exposure-at-the-wafer and the projected-image-of-the-reticle during exposure may be measured real time. This is different from known methods, wherein reticle and wafer stage are controlled independently. An advantage of the disclosed method is that also dynamic deformations in wafer position and shape in the exposed die and in projected reticle pattern may be measured. Such deformations can become significant and are caused by e. g. wafer heating during exposure, a rather unpredictable phenomenon that depends on die design, expose beam intensity, expose speed etc.

In a method, the combination of a patterned expose beam and a patterned fluorescent marker on a wafer is used to generate a fluorescent signal that carries real-time information of the overlay of the expose die pattern with a die pattern that is already present on the wafer. This signal can be logged to provide information on the overlay accuracy of the exposure. This signal can also be used to improve the position control of the wafer and/or reticle stage during the exposure, and thus improve the overlay (and hence yield of the lithography process), especially for multiple patterning processing (double, triple etc. patterning) as those exposure methods may raise strict requirements for overlay accuracy.

Achieving sufficient overlay with a lithography apparatus may be increasingly difficult with known "passive" methods, such as e.g. feed-forward of alignment errors based on overlay fingerprints that result from statistical averaging (die-to-die within wafer or between wafers, die-to-design, etc.). In the presently disclosed method the exposure beam itself is used to generate a quantitative signal for the overlay error. For a practical realization, several changes to the exposure process, stepper design and reticle lay out may be carried out. The next list comprises examples of additions or modifications to lithography-related items, methods or system parts:
1) Overlay Marker design on reticle and wafer- The currently disclosed systems and methods use a matched pair of markers on both the wafer and the reticle. The absorber pattern on the reticle patterns the expose beam, the fluorescent pattern on the wafer generates a fluorescent signal is generated that represents the (error in the) overlay, while being exposed by the patterned expose beam. The exact pattern design can vary, but will typically contain a grating. The pattern can consist of multiple smaller markers that each addresses a direction of the overlay error in a specific part of the exposed die.
   It will be clear to those skilled in the art that the advanced spatial design of the matched pair of markers can create a fluorescent signal strength that is related or even proportional to the error in the overlay of the expose pattern with the layer that contains the fluorescent marker.
2) Fluorescent signal detector - Somewhere the generated fluorescent signal may be recorded. For example one can put a spectrally filtered photon counter close to the expose area of the wafer. Alternatively, a detector can be placed close to the reticle, since the optics column of the stepper will project the fluorescence signal back on that plane, and projector lens aberrations (e.g. chromatic, field distortion or spherical) and/or a spectral filter can separate the fluorescent photons from the expose beam to create a strong and reliable signal on the detector.
3) Electronic signal processor - The detected fluorescence signal may be calibrated into nanometers using a test protocol and signal processing and storage. When the signal is to be used for active stage position control, sufficient bandwidth is preferably present in al chains from the fluorescent marker, the detector, the processing unit and the stage control electronics.

The various elements of the embodiments as discussed and shown offer certain advantages, such as providing a method for real-time overlay monitoring in a lithographic apparatus. Of course, it is to be appreciated that any one of the above embodiments or processes may be combined with one or more other embodiments or processes to provide even further improvements in finding and matching designs and advantages. It is to be appreciated that the current disclosure offers particular advantages for multiple patterning processes, and in general can be applied for any exposure apparatus to determine a position of an exposure pattern. It is noted that while in most embodiments, a misalignment is indicated by the presence of fluorescent radiation, alternatively this may be reversed, i.e. a misalignment could also be indicated by the lack of fluorescent radiation wherein the position controller would try to maximize the fluorescent radiation registered by the position sensor for proper alignment.

Finally, the above-discussion is intended to be merely illustrative of the present system and should not be construed as limiting the appended claims to any particular embodiment or group of embodiments. Thus, while the present system has been described in particular detail with reference to specific exemplary embodiments thereof, it should also be appreciated that numerous modifications and alternative embodiments may be devised by those having ordinary skill in the art without departing from the broader and intended spirit and scope of the present system as set forth in the claims that follow. The specification and drawings are accordingly to be regarded in an illustrative manner and are not intended to limit the scope of the appended claims.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise; no specific sequence of acts or steps is intended to be required unless specifically indicated; and no specific ordering of elements is intended to be required unless specifically indicated.

## Claims

1. Chip die manufacturing system (1) comprising
- a wafer stage (2) arranged for holding and positioning a wafer (12);
- a reticle stage (3) arranged for holding and positioning a reticle (13b) comprising a mask pattern (32) comprising a chip die pattern (22);
- an illumination system (4) arranged for irradiating the mask pattern (32) with exposure radiation (15) from a radiation source (5);
- a projection system (6) arranged for projecting patterned exposure radiation (15) from the mask pattern (32) onto the wafer (12);
- a position controller (7) arranged for controlling a position of the wafer stage (3) and/or the reticle stage (2);
- a position sensor (8) arranged for detecting a position of the wafer (12) by means of an alignment mark (23) on the wafer (12) ; and
- a feedback circuit (9) arranged for receiving input from the position sensor (8) and providing feedback to the position controller (7) for adjusting the position of the wafer stage (2) and/or reticle stage (3) as a function of said feedback; **wherein**, in use, an alignment mark (23) comprises a patterned material (123) having a fluorescent frequency-shifted response to the exposure radiation (15) of the radiation source (5) and the mask pattern (32) comprises a corresponding marker scan pattern (24) forming a matched pair with the alignment mark (23), such that during the projecting of the chip die pattern (22) a fluorescent signal (14), emanating from parts of the alignment mark (23) irradiated by patterned exposure radiation (15) of the marker scan pattern (24), is directed towards the position sensor (8);
- the position sensor (8) is arranged for detecting the fluorescent signal (14) and providing real-time input (Ss) to the feedback circuit (9);
- the feedback circuit (9) is arranged for providing real-time feedback (Sf) to the position controller (7); and
- the position controller (7) is arranged for adjusting a position of the wafer stage (2) and/or the reticle stage (3) during or directly after the projecting of the chip die pattern (25) as a function of said real-time feedback (Sf).

2. System according to any of the previous claims, wherein the position sensor (8) is arranged for detecting the fluorescent signal (14) by means of a radiation filter (11), wherein the radiation filter (11) is arranged in a light path of the fluorescent signal (14) between the alignment mark (23) on the wafer (12) and the position sensor (8), wherein the radiation filter (11) is arranged for filtering out exposure radiation (15) from the radiation source (5) while passing the fluorescent signal (14) to the position sensor (8).

3. System according to any of the previous claims, wherein the projection system 6 is arranged in a light path of the fluorescent signal (14) between the alignment mark (23) on the wafer (12) and the position sensor (8).

4. System according to any of the previous claims, wherein the alignment mark (23) is located on a scribe line (25,26) between chip dies to be created on the wafer (13) and the projection system (6) is arranged for projecting the marker scan pattern (24) comprised in the mask pattern (32) onto the scribe line (25,26).

5. System according to any of the previous claims, further comprising a memory device operatively linked to the feedback device and the position controller for the purpose of keeping track of misalignments during the projecting of the chip die pattern.

6. Method for position control in a chip die manufacturing system, the method comprising
- holding and positioning the wafer (12);
- holding and positioning a reticle (13b) comprising a mask pattern (32) comprising a chip die pattern (22);
- irradiating the mask pattern (32) with exposure radiation (15) from a radiation source (5);
- projecting patterned exposure radiation (15) from the mask pattern (32) onto the wafer (12);
- controlling a position of the wafer stage (3) and/or the reticle stage (2);
- detecting a position of the wafer (12) by means of an alignment mark (23) on the wafer (12); and
- providing feedback of the detected position of the wafer (12) for adjusting the position of the wafer (12) and/or reticle (13) as a function of said feedback; wherein, the alignment mark (23) comprises a patterned material (123) having a fluorescent frequency-shifted response to the exposure radiation (15) of the radiation source (5) and the mask pattern (32) comprises a corresponding marker scan pattern (24) forming a matched pair with the alignment mark (23), such that during the projecting of the chip die pattern (22) a fluorescent signal (14), emanating from parts of the alignment mark (23) irradiated by the patterned exposure radiation (15a) of the marker scan pattern (24) is detected for providing real-time feedback for adjusting a position of the wafer (12) and/or the reticle (13) during or directly after the projecting of the chip die pattern (25) as a function of said real-time feedback.

7. Method according to claim 6, wherein the alignment mark (23) is produced by
- Holding and positioning a first reticle (13a) comprising a first mask pattern (31) comprising a pattern of the alignment mark (23);
- irradiating the first mask pattern (31) with exposure radiation (15) from the radiation source (5);
- projecting an image of the first mask pattern (31) onto the wafer (12); and
- developing the wafer (12) to produce the alignment mark (23) comprising the patterned material (123) having a fluorescent frequency-shifted response to the exposure radiation (15).

8. Method according to claim 7, wherein the first mask pattern (31) further comprises another chip die pattern (21) that forms a multi patterning pair with the chip die pattern (22) of a subsequent projection step (C,D), wherein the another chip die pattern (21) is projected simultaneously with the pattern of the alignment mask (23) as a first step in a multi patterning process.

9. Method according to claim 7 or 8, wherein the pattern of the alignment mark (23) is projected (A) on a part of the wafer (12) comprising the material (123) having a fluorescent frequency-shifted response to the exposure radiation (15).

10. Method according to claim 9, wherein the said part of the wafer (12) comprises scribe lines (25,26) on the wafer (12) between positions where the chip die patterns (21,22) are to be projected.

11. Method according to claim 9 or 10, wherein the material (123) having a fluorescent frequency-shifted response to the exposure radiation (15) is applied to the said part of the wafer (12) by a printing step before the projecting of the pattern of the alignment mark (23).

12. Semiconductor wafer (12) for use in a lithographic apparatus (1), the wafer (12) comprising a fluorescent material (123) having a fluorescent frequency-shifted response (14) to exposure radiation (15) that is used for exposing chip die patterns on the wafer (12) in the said lithographic apparatus (1).

13. Semiconductor wafer (12) according to claim 12, wherein the fluorescent material comprises two or more substances (123a, 123b) with a distinct fluorescence spectrum (14a, 14b) to the exposure radiation (15).

14. Semiconductor wafer (12) according to claim 12 or 13, wherein a pattern of an alignment marker (23) is applied to the fluorescent material (123), the pattern of the alignment marker (23) matching a corresponding marker scan pattern (24) on a mask (13) such that an overlap between the alignment marker (23) and the marker scan pattern (24) provides a measure of an alignment position of the semiconductor wafer (12).

15. Semiconductor wafer (12) according to any of the claims 12 - 14 wherein a pattern of an alignment marker (23) is applied to the fluorescent material (123), the pattern of the alignment marker comprising parallel lines that are at least 50 nm wide.
